# EUROPEAN PATENT SPECIFICATION

(11) **EP 0 771 181 B1**
(45) Date of publication and mention of the grant of the patent: **05.12.2001**
(21) Application number: 95925502.7
(22) Date of filing: 10.07.1995
(51) Int. Cl.: A61F 13/02, B32B 9/04, B65C 9/00, B32B 31/12

(54) **SHEETS WITH HIGH TEMPERATURE STABLE PROTECTIVE COATING**
FOLIEN MIT BEI HOHEN TEMPERATUREN STABILER SCHUTZSCHICHT
FEUILLES MUNIES D'UN REVETEMENT PROTECTEUR STABLE A HAUTE TEMPERATURE

(30) Priority: 08.07.1994 US 278871
(43) Date of publication of application: 07.05.1997
(73) Proprietor: Metallized Products Inc., Winchester, MA 10890 (US)
(72) Inventor: Wilheim, Martin, Larchmont, NY 10538 (US); Keough, Allen H., Northboro, MA 01532 (US)
(74) Representative: Allsop, John Rowland
(86) International application number: US9508436
(87) International publication number: WO9601605

(56) References cited:
- EP-A- 0 429 099
- EP-A- 0 535 868
- US-A- 4 753 847
- US-A- 4 875 283
- US-A- 5 110 668

## Description

### FIELD OF THE INVENTION

The present invention relates to a method for protecting the surface of a metal foil or other substrate sheet and to a laminate sheet product. More particularly, the present invention especially relates to a method for protecting an etchable conductive metal foil using an electron beam cured coating to protect the foil from damage during handling and subsequent processing into a printed circuit board.

### BACKGROUND OF THE INVENTION

Printed circuit boards having a high density of electrical interconnections and circuitry have been developed from multilayer printed circuit board laminates, such as epoxy resin prepregs, to meet the needs for miniaturized electronic components. The multilayer printed circuit board laminates are made from suitable reinforced resin materials and metal foils, particularly copper foils, which are processed together at high temperature and pressure. The laminates are then used in the manufacture of printed circuit boards.

A printed circuit board is made from a laminate by etching away portions of the conductive foil from the laminate surface to leave distinct patterns of conductive lines and formed elements on the surface of the etched laminate. Additional laminates and/or laminate materials are then packaged together with the etched product to form a multilayer circuit board package. Additional processing, such as hole drilling and component attaching completes the printed circuit board package. While printed circuit boards are known, printed circuit board technology continues to advance to provide higher density boards with smaller printed circuit lines. Miniaturization has advanced to the point that surface contamination of the raw materials has now become a significant problem, and generally cannot be tolerated in commercial application.

During the high-pressure and high-temperature lamination of the thin metal, for example copper foils, thin plastic lamination mold release coating films or layers have been successfully temporarily interposed on the foil to minimize deleterious effects upon the foil surfaces during such lamination, as described, for example, in U.S. Patent 4,753,847. Among such removable interposed layers have been sheets of polyvinyl fluoride and the like, such as those of the "Tedlar" type of the Dupont Company.

As for protection during handling and otherwise before lamination a clean environment is one way to avoid, or at least minimize contamination problems. Another way to avoid or minimize problems is to use protective films as is, for example, disclosed in U.S. Patent 5,120,590 which issued June 9, 1992 to Savage *et al* for "Protective Conductive Foil and Procedure for Protecting an Electrodeposited Metallic Foil During Further Processing".

The present invention provides a further alternative way to protect surfaces of sheets and to avoid, or at least minimize, contamination problems in the manufacture of circuit boards. In accordance with the present invention it has been found that electron beam cured adhesive coatings are especially advantageous in bonding a protective film to a foil laminate to be made into a printed circuit board. The electron beam cured adhesives have high temperature stability and are characterized by low tack and high cohesive strength. Thus, the present invention provides a foil laminate having a foil protecting film adhered to the foil by an electron beam cured adhesive. The film can be readily removed from the foil surface after it has served its protective purpose for subsequent processing of the foil. No visible residue is left on the foil. Furthermore, the adhesive used in this invention can be applied across the entire surface of the protective film without concern of film placement over the foil surface, nor of the effects of elevated temperature and pressure on the chemical structure of said adhesive.

### SUMMARY OF THE INVENTION

According to one aspect of the invention there is provided a method for protecting the surface of a substrate sheet such as a conductive foil suitable for use in the manufacture of printed circuit boards, which method is defined in claim 1.

According to another aspect of the invention there is provided a protected sheet laminate which is defined in claim 9.

Preferably, the substrate sheet is a foil laminate suitable for use in the manufacture of a printed circuit board, the electron beam cured adhesive is a continuous coating on the foil, and the release coating is either an electron beam cured release coating or a vacuum deposited aluminum release coating.

### BRIEF DESCRIPTION OF THE DRAWING

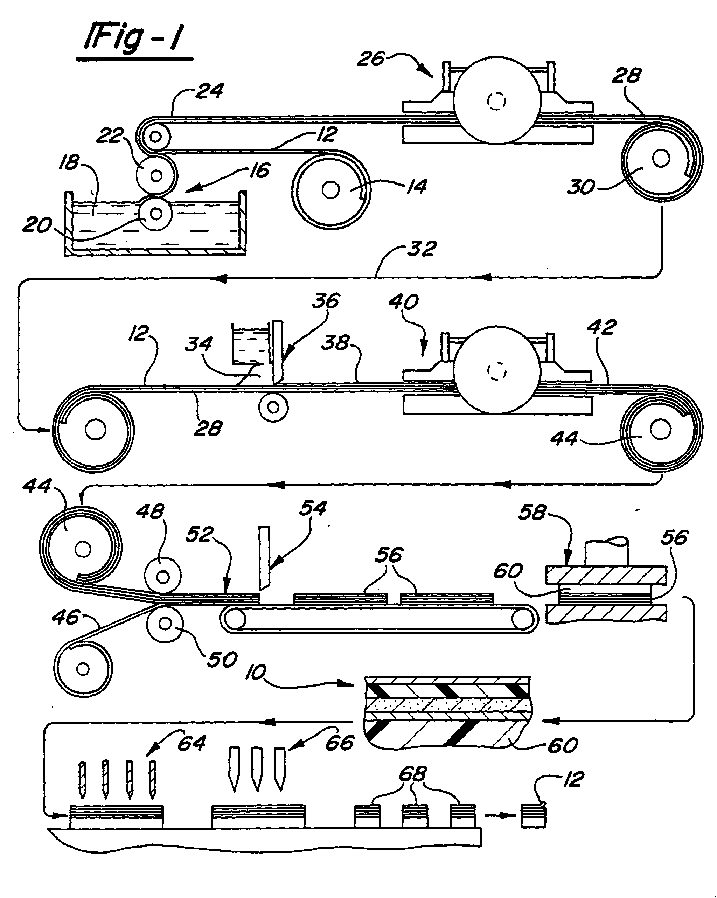

Figure 1 is a somewhat schematic view illustrating a preferred embodiment of the process of the present invention.

### DESCRIPTION OF THE PREFERRED EMBODIMENTS

Now referring to the Figure, Figure 1 illustrates a preferred embodiment of the process of the present invention and show a cross-section of a preferred product of the present invention, indicated generally by the numeral 10. While the preferred embodiment of the present invention is described in terms of foil laminates used in making printed circuit boards, it will be appreciated by those skilled in the art that, broadly speaking, this invention is applicable to substrate sheets other than foil laminates and, hence, to other products. Thus, for instance, the protected substrate sheet can be glass, polycarbonate or acrylic resin.

In accordance with the process of Figure 1, protective film 12, for example, a polyester film, is unwound from roll 14 and is passed through offset gravure coating station 16. Any suitable protective film 12 can be used in the present invention and suitable films 12 are well known in the art. At offset gravure coating station 16 an electron beam curable release coating material 18 is taken up by roller 20, transferred to roller 22, and applied to one side of film 12 as a continuous coating 24, thereon. Suitable electron beam curable release coatings are well known in the art. Such coatings enjoy substantially consistent release characteristics during subsequent processing steps. Film 12 with coating 24 is then passed through an electron beam curing apparatus 26 where an electron beam is applied to coating 24 which is thereby cured to form cured release coating 28. Suitable electron beam curing apparatus is commercially available and the amount of energy to be applied to effect curing is well within the skill of an artisan. Film 12 with now cured release coating 28 thereon is wound onto roll 30. Alternatively, a release coating is provided on a film 12 by vacuum metallizing a layer or coating of aluminum thereon.

Roll 30 is then turned over as indicated at arrow 32 and film 12 with cured coating 28 thereon is unwound from roll 30 and an electron beam curable adhesive coating material 34 is applied by a "knife over roll" applicator 36 to the previously uncoated side of film 12. The adhesive coating material comprises a saturated copolyester with terminal acrylic double bonds such materials are known in the art. Film 12 with adhesive coating 38 is then passed through electron beam curing apparatus 40 and an electron beam is applied to cure adhesive material 30 on film 12 to form cured coating 42. The electron beam cured adhesive is characterized by high temperature stability, low tack, and high cohesive strength. Film 12 is rewound onto roll 44 and the adhesive side thereof is applied to a copper foil sheet 46 between rolls 48 and 50. The now protected foil sheet 52 is cut at station 54 to provide foil sheet laminates 56 which are heated and pressed in press 58 with a dielectric epoxy prepreg sheet 60 to bond the sheets together to form laminate 10. Laminate 10 is allowed to cool, transported, then further processed by suitable conventional processes such as drilling at 64 and cutting at 66 to provide a circuit board laminate 68. Before etching of the foil film 12 is removed as shown at 70.

Further understanding of the present invention will be had from the following specific examples.

### EXAMPLE 1

A polyester film (92ga Melinex 314, ICI Resins) was installed in a coating machine equipped with an electron processor, manufactured by Energy Sciences, Inc. An electron beam curable release coating, such as that disclosed in U.S. Patent 4,753,847, was applied by an offset gravure application station to one side of the polyester film at a coating weight of approximately 3 Ibs. per 3000 sq. ft. and cured by electron beam at a dose a 3 megarads. The film was turned over, and Dynacoll A 2583 from Huls America, Inc., heated to suitable application viscosity (about 100°C), was applied by a "knife over roll" applicator to the other side of the polyester film, and cured at a dose of 3 megarads at 165KUs. The adhesive side of the resulting roll of film was easily releasable from the opposite side release layer and was applied to a copper foil sheet laminate, and pressed at 350°F at 500 psi for 90 minutes. Following the press cycle, the sample was allowed to cool, and the protective film was easily removed from the copper sheet. There was no visible evidence of surface contamination on the copper foil.

### EXAMPLE 2

A roll of 48ga polyester film chemically treated on one side (ICI type 813) was converted in a commercial vacuum metallizer for the deposition of aluminum from induction heated curable onto the untreated side of the film to an aluminum thickness of about 3 ohms per square. The metallized polyester was then converted in accordance with Example 1 with Dynacoll A 2583 adhesive from a "knife-over-roll" device to the opposite side, i.e. the treated side, of the polyester film, and cured by electron beam radiation at a dose of 4 megarads.

The cured adhesive can easily be released from the metallized surface which acts as a release layer.

## Claims

1. A method for protecting the surface of a substrate sheet (46) such as a conductive foil suitable for use in the manufacture of printed circuit boards, comprising the steps of: providing a release coating (24, 28) on one side of a protective film (12); **characterized by** applying an electron beam curable adhesive coating material comprising a saturated copolyester with terminal acrylic double bonds (34, 38) to the other side of the protective film (12); electron beam curing said polyester adhesive coating (34, 38); and laminating the thus processed protective film (12) via said cured adhesive coating (42) thereon to the substrate sheet (46), thereby to protect the substrate sheet (46) until removal therefrom.

2. A method as claimed in Claim 1 **characterized in that** said release coating is provided by applying an electron beam curable release coating (24) to one side of said film and curing said release coating to form a cured release coating (28).

3. A method as claimed in Claim 1 **characterized in that** said release coating (24) is provided by vacuum depositing a coating of aluminum on one side of said film (12).

4. A method as claimed in Claim 1 **characterized in that** said substrate sheet (46) is a copper foil laminate.

5. A method as claimed in Claim 1 **characterized in that** said film (12) is a polyester film.

6. A method as claimed in Claim 1 **characterized in that** lamination of the protective film (12) is carried out under heat and pressure and said substrate sheet (46) is a dielectric.

7. A method as claimed in Claim 1 **characterized in that** said substrate sheet (46) is polycarbonate.

8. A method as claimed in Claim 1 **characterized in that** said substrate sheet (46) is acrylic.

9. A protected sheet laminate comprising a substrate foil sheet (46), a protective film (12) laminated to said substrate sheet, **characterized in that** said film (12) is provided with a release coating (24,28) on one side and a cured polyester adhesive coating (42) on the other side, said other side being in adhesive contacting relationship with said substrate sheet (46), wherein the adhesive coating is obtainable by applying and electron beam curing an adhesive coating material comprising a saturated copolyester with terminal acrylic double bonds.

10. A sheet as claimed in Claim 9 **characterized in that** said release coating is an electron beam cured polymeric release coating (28).

11. A sheet as claimed in Claim 9 **characterized in that** said release coating is a vacuum deposited aluminum coating.

12. A sheet as claimed in Claim 9 **characterized in that** said substrate sheet (46) is a copper foil laminate.

## Patentansprüche

1. Verfahren zum Schützen der Oberfläche eines Substrat-Flachmaterials, beispielsweise einer leitenden Folie, die für die Herstellung von Leiterplatten geeignet ist, wobei das Verfahren Verfahrensschritte für das Aufbringen einer Trennbeschichtung oder Trennschicht (24, 28) auf eine Seite eines Schutzfilmes (12) umfaßt, **gekennzeichnet durch** Aufbringen einer **durch** einen Elektronenstrahl aushärtbaren Kleberbeschichtung, welche ein gesättigtes Copolymer mit Acryldoppelendbindungen (34, 38) aufweist, auf die andere Seite des Schutzfilmes (12), **durch** Aushärten des Polymer- Kleberbeschichtung (34, 38) **durch** einen Elektronenstrahl, und **durch** Laminieren des auf diese Weise verarbeiteten Schutzfilmes (12) mittels der ausgehärteten Kleberbeschichtung (42) mit dem Substratflachmaterial (46), um hierdurch das Substratflachmaterial (46) bis zum Entfernen von diesem Material zu schützen.

2. Verfahren nach Anspruch 1, **dadurch gekennzeichnet, daß** die Trennschicht durch Aufbringen einer durch einen Elektronenstrahl aushärtbaren und als Trennschicht wirksamen Beschichtung (24) auf die eine Seite des Filmes sowie durch Aushärten dieser Beschichtung erzeugt wird, um so eine ausgehärtete Trennschicht (28) zu bilden.

3. Verfahren nach Anspruch 1, **dadurch gekennzeichnet, daß** die Trennschicht (24) durch Vakuumabscheiden einer Schicht aus Aluminium auf eine Seite des Filmes (12) erzeugt wird.

4. Verfahren nach Anspruch 1, **dadurch gekennzeichnet, daß** das Substratflachmaterial (46) ein Kupferfolienlaminat ist.

5. Verfahren nach Anspruch 1, **dadurch gekennzeichnet, daß** der erwähnte Film (12) ein Polyesterfilm ist.

6. Verfahren nach Anspruch 1, **dadurch gekennzeichnet, daß** die Laminierung des Schutzfilmes (12) unter Hitze und Druck ausgeführt wird, und daß das erwähnte Substratflachmaterial (46) ein Dielektrikum ist.

7. Verfahren nach Anspruch 1, **dadurch gekennzeichnet, daß** das erwähnte Substratflachmaterial (46) ein Polycarbonat ist.

8. Verfahren nach Anspruch 1, **dadurch gekennzeichnet, daß** das erwähnte Substratflachmaterial (46) ein Acryl-Material ist.

9. Ein geschütztes Flachmaterial in Form eines Laminats bestehend aus einem Substratflachmaterial (46), einem Schutzfilm (12), der mit dem Substratflachmaterial verbunden ist, **dadurch gekennzeichnet, daß** der erwähnte Film (12) mit einer Trennschicht (24, 28) an einer Oberflächenseite und mit einer ausgehärteten Polyester-Kleberschicht (42) an der anderen Oberflächenseite versehen ist, wobei die andere Seite in Klebekontakt mit dem Substrat Flachmaterial (46) steht, wobei der Kleberüberzug durch Aufbringen eines durch Elektronenstrahl aushärtbaren klebenden Beschichtungsmaterials erhaltbar ist, welches ein gesättigtes Copolyester mit Acryldoppelbindungen am Ende aufweist.

10. Flachmaterial nach Anspruch 9, **dadurch gekennzeichnet, daß** die erwähnte Trennschicht eine durch einen Elektronenstrahl aushärtbare Polymer-Trennschichtbeschichtung (28) ist.

11. Flachmaterial nach Anspruch 9, **dadurch gekennzeichnet, daß** die erwähnte Trennschicht eine durch Vakuumabscheiden erzeugte Aluminiumschicht ist.

12. Flachmaterial nach Anspruch 9, **dadurch gekennzeichnet, daß** das Substratflachmaterial (46) ein Kupferfolienlaminat ist.

## Revendications

1. Une méthode de protection de la surface d'une feuille de substrat (46), telle qu'une feuille conductrice pouvant être utilisée dans la fabrication des cartes de circuit imprimés, comportant les phases suivantes: le dépôt d'une couche de démoulage (24, 28) sur l'une des faces d'un film de protection (12); **caractérisé par** l'application d'une couche de matière adhésive durcissable par faisceau d'électrons et comportant un co-polyester saturé avec doubles liaisons terminales acryliques (34, 38) sur l'autre face du film de protection (12); le' durcissement par faisceau d'électrons de ladite couche adhésive polyester (34, 38); et le laminage dudit film de protection ainsi traité (12) par ladite couche adhésive durcie (42) sur la feuille de substrat (46), pour protéger celle-ci (46), jusqu'à ce que ladite couche en soit retirée.

2. Une méthode telle que revendiquée dans la Revendication 1 **caractérisée par le fait que** ladite couche de démoulage est déposée en appliquant une couche de démoulage durcissable par faisceau d'électrons (24) sur l'une des faces dudit film et en durcissant ladite couche de démoulage pour former une couche de démoulage durcie (28).

3. Une méthode telle que revendiquée dans la Revendication 1 **caractérisée par le fait que** ladite couche de démoulage (24) est obtenue en déposant sous vide une couche d'aluminium sur l'une des faces audit film (12).

4. Une méthode telle que revendiquée dans la Revendication 1 **caractérisée par le fait que** ladite feuille de substrat (46) est une feuille de cuivre laminée.

5. Une méthode telle que revendiquée dans la Revendication 1 **caractérisée par le fait que** ledit film (12) est un film polyester.

6. Une méthode telle que revendiquée dans la Revendication 1 **caractérisée par le fait que** le laminage dudit film de protection (12) est effectué à chaud et sous pression et que ladite feuille de substrat (46) est une feuille diélectrique.

7. Une méthode telle que revendiquée dans la Revendication 1 **caractérisée par le fait que** ladite feuille de substrat (46) est une feuille de polycarbonate.

8. Une méthode telle que revendiquée dans la Revendication 1 **caractérisée par le fait que** ladite feuille de substrat (46) est une feuille acrylique.

9. Une feuille laminée protégée comportant une feuille de substrat (46), un film de protection (12) laminé sur ladite feuille de substrat, **caractérisée par le fait que** ledit film (12) fourni avec une couche de démoulage (24, 28) sur une face et une couche adhésive polyester durcie (42) sur l'autre face ladite autre face étant dans une relation de contact adhésif avec ladite feuille de substrat (46), dans laquelle la couche adhésive peut être obtenue en appliquant un faisceau d'électrons durcissant une couche de matière adhésive comportant un co-polyester saturé avec doubles liaisons terminales acryliques.

10. Une feuille telle que revendiquée dans la Revendication 9, **caractérisée par le fait que** ladite couche de démoulage est une couche de démoulage polymère durcissable par faisceau d'électrons (28).

11. Une feuille telle que revendiquée dans la Revendication 9. **caractérisée par le fait que** ladite couche de démoulage est une couche d'aluminium déposée sous vide.

12. Une feuille telle que revendiquée dans la Revendication 9, **caractérisée par le fait que** ladite feuille de substrat (46) est une feuille de cuivre laminée.
